# EUROPÄISCHE PATENTSCHRIFT

(11) **EP 0 471 935 B1**
(45) Veröffentlichungstag und Bekanntmachung des Hinweises auf die Patenterteilung: **14.09.1994**
(21) Anmeldenummer: 91109646.9
(22) Anmeldetag: 12.06.1991
(51) Int. Cl.: G09G 3/20, G06F 11/16, G09F 9/37

(54) **Schaltungsanordnung zum Überwachen einer Matrix aus bistabilen Matrixpunkten**
Circuit for supervising a matrix of bistable points
Circuit de surveillance d'une matrice de points bistables

(30) Priorität: 02.08.1990 DE 4024499
(43) Veröffentlichungstag der Anmeldung: 26.02.1992
(73) Patentinhaber: Dambach-Werke GmbH, D-76571 Gaggenau (DE)
(72) Erfinder: Killinger, Erich, Dr.-Ing., W-7560 Gaggenau (DE)
(74) Vertreter: Vogel, Georg

(56) Entgegenhaltungen:
- EP-A- 0 167 445
- US-A- 4 069 480
- PATENT ABSTRACTS OF JAPAN, vol. 12, no. 463 (P-796), 6 December 1988 & JP-A-63186165
- PATENT ABSTRACTS OF JAPAN, vol. 13, no. 57 (P-825), 9 February 1989 & JP-A-63246727
- DER ELEKTRONIKER, vol. 7, 1984, Stuttgart, DE, pages 62-65; B. Karpf: "Bistabile elektromagnetische Grossanzeigen"

## Beschreibung

Die Erfindung betrifft eine Schaltungsanordnung für eine Anzeigevorrichtung mit einer aus n Zeilen und m Spalten bestehenden Matrix aus bistabilen Matrixpunkten, die jeweils einen Elektromagneten aufweisen, dessen einer Anschluß mit seiner zugeordneten Spaltenleitung und dessen anderer Anschluß stromrichtungsabhängig über entgegengesetzt gepolte Dioden mit seiner zugeordneten Zeilen-Setzleitung und seiner zugeordneten Zeilen-Rücksetzleitung verbunden sind, bei der die Spaltenleitungen, die Zeilen-Setzleitungen und die Zeilen-Rücksetzleitungen der Matrix über einen Prozessor, einen Spaltendekoder und einen Zeilendekoder beim Setzen oder Rücksetzen so ansteuerbar sind, daß die Spaltenleitungen zyklisch nacheinander mit Setzgegenpotential oder Rücksetzgegenpotential ansteuerbar sind, wobei bei jeder einzelnen Spaltenansteuerung zyklisch nacheinander alle Zeilen-Setzleitungen mit Setzpotential oder alle Zeilen-Rücksetzleitungen mit Rücksetzpotential ansteuerbar sind.

Eine Schaltungsanordnung dieser Art ist aus B. Karpf: "Bistabile elektromagnetische Großanzeigen" in "Der Elektroniker" 7/84, Seiten 62 bis 65, bekannt. Diese bekannte Schaltungsanordnung dient lediglich zum Setzen und Rücksetzen der Matrixpunkte, eine Überwachung mit Überprüfung der einzelnen Matrixpunkte ist bei dieser bekannten Schaltungsanordnung nicht vorgesehen.

Aus der Zeitschrift eee, Nummer 23 vom 18. Nov. 1986 ist auf den Seiten 32 und 34 eine Matrixansteuerung gezeigt, bei der die Ansteuersignale über Optokoppler auf die Zeilenleitungen der Matrix gegeben werden. Auch diese bekannte Matrixansteuerung weist keine Überwachung der Matrixpunkte auf.

Es ist Aufgabe der Erfindung, eine Schaltungsanordnung der eingangs erwähnten Art zu schaffen, mit der beim Setzen und beim Rücksetzen der Matrixpunkte eine Überprüfung der Matrix auf Fehler vorgenommen wird, ohne daß dafür ein erheblicher Mehraufwand erforderlich ist.

Diese Aufgabe wird nach der Erfindung wie beansprucht dadurch gelöst, daß mit jeder Spaltenleitung eine an dem Setzpotential liegende erste Optokoppler-Leuchtdiode verbunden ist, die bei angelegtem Setzgegenpotential ein erstes Ausgangssignal abgibt, daß mit jeder Spaltenleitung eine an dem Rücksetzpotential liegende zweite Optokoppler-Leuchtdiode verbunden ist, die bei angelegtem Rücksetzgegenpotential ein zweites Ausgangssignal abgibt, daß mit jeder Zeilen-Setzleitung eine an dem Setzgegenpotential liegende dritte Optokoppler-Leuchtdiode verbunden ist, die bei angelegtem Setzpotential ein drittes Ausgangssignal abgibt, daß mit jeder Zeilen-Rücksetzleitung eine an dem Rücksetzgegenpotential liegende vierte Optokoppler-Leuchtdiode verbunden ist, die bei angelegtem Rücksetzpotential ein viertes Ausgangssignal abgibt, daß die Optokoppler-Leuchtdioden mittels zugeordneter Fotoempfänger Ausgangssignale einem Codewandler zuführen, der eine Vergleichsinformation an den Prozessor abgibt, und daß der Prozessor diese Vergleichsinformation auf Übereinstimmung mit der dem Spaltendekoder und dem Zeilendekoder zugeführten Setz- oder Rücksetzinformation überprüft und bei ein- oder mehrmaligem Fehlen der Übereinstimmung ein Fehlersignal abgibt.

Mit Hilfe der an die Spaltenleitungen, die Zeilen-Setzleitungen und die Zeilen-Rücksetzleitungen angelegten Potentiale und angeschalteten Optokoppler kann bei jedem Setz- und Rücksetzvorgang ein Teil der Matrix überprüft werden. Es darf sowohl beim Setzen als auch beim Rücksetzen stets nur ein einziger Optokoppler ansprechen. Dies wird durch den zusätzlichen Codewandler überwacht, der nur bei ordnungsgemäß anstehender Ausgangsinformation der Optokoppler eine zugeordnete Information an den Prozessor abgibt. Dabei kann der Codewandler z.B. eine Binärinformation weiterleiten, um die Anzahl der Informationsleitungen zu reduzieren. Der Prozessor kann auf einfache Weise, z.B. über eine Tabelle, die vom Codewandler zugeführte Information mit der Setz- oder Rücksetzinformation vergleichen, die er gerade an den Spaltendekoder und den Zeilendekoder abgibt. Auf diese Weise wird bei jedem Setz- und Rücksetzvorgang der beteiligte Teil der Matrix überprüft.

Um Kurzschlüsse und Unterbrechungen eines Matrixpunktes erfassen zu können, sieht eine Ausgestaltung vor, daß mittels Stromüberwachungsschaltungen beim Setzen und Rücksetzen ein vorgebbarer Strombereich überwacht ist. Der vorgebbare Strombereich ist dabei durch den Minimal- und Maximalstrom des Matrixpunktes vorgegeben und die Stromüberwachungsschaltungen sind im Zeilendekoder in die Leitungen zum Setz- und Rücksetzpotential eingeschleift.

Für die Fehleranzeige ist nach einer weiteren Ausgestaltung vorgesehen, daß das Fehlersignal auch auftritt, wenn die Stromüberwachungsschaltungen ein Unter- oder Überschreiten des vorgebbaren Strombereiches feststellen.

Das Setzen und Rücksetzen eines Matrixpunktes ist dabei vorzugsweise so, daß die Ansteuerung der Spaltenleitungen mit dem Setzgegenpotential bzw. dem Rücksetzgegenpotential und die Ansteuerung der Zeilen-Setzleitungen mit Setzpotential bzw. der Zeilen-Rücksetzleitungen mit Rücksetzpotential synchron und impulsförmig erfolgen.

Der Strombereich eines Matrixpunktes läßt sich auch so überwachen, daß der Setz- und der Rücksetzstromkreis über eine gemeinsame Stromüberwachungsschaltung geführt ist, die im Stromversorgungs-Leistungsteil untergebracht ist.

Der Rücksetzvorgang läßt sich nach einer Ausgestaltung dadurch verkürzen, daß beim Rücksetzen eine Spaltenleitung und gleichzeitig mehrere Zeilen-Rücksetzleitungen ansteuerbar sind und daß in jede Zeilen-Rücksetzleitung eine Stromüberwachungsschaltung eingeschleift ist.

Der Aufbau der Matrix kann auch so sein, daß die Spalten und die Zeilen vertauschbar sind.

Die Erfindung wird anhand eines in den Zeichnungen dargestellten Ausführungsbeispiels näher erläutert. Es zeigt:
- Fig. 1: schematisch eine Matrix mit Matrixpunkten und Prüfstromkreisen zum Feststellen von Fehlern in der Matrix, wobei der Matrixpunkt der Spalte 1 und der Zeile 1 gesetzt wird, und
- Fig. 2: denselben Matrixaufbau, wobei allerdings der Matrixpunkt der Spalte 1 und der Zeile 1 gerade zurückgesetzt wird.

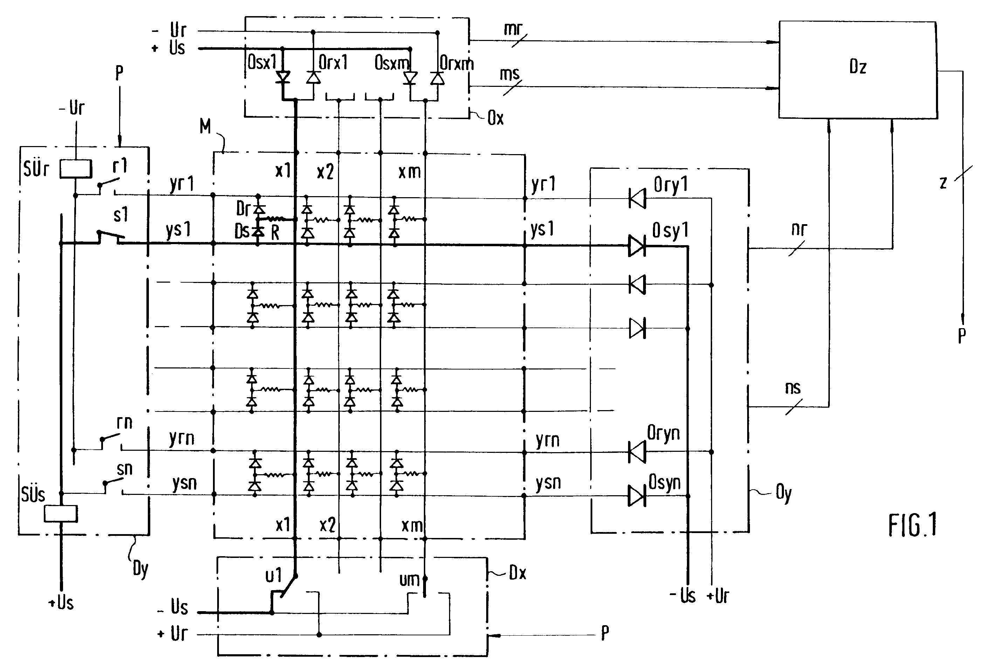

Der Aufbau einer Matrix M besteht aus m Spalten und n Zeilen. An den Kreuzungspunkten von Spaltenleitungen x1 bis xm und Zeilenleitungen ys1 bis ysn bzw. yr1 bis yrn sind die aus einem Elektromagneten R und aus zwei Dioden Ds und Dr bestehenden Matrixpunkte angeschaltet. Wie die Fig. 1 zeigt, ist der eine Anschluß des Elektromagneten R an die zugeordnete Spaltenleitung x1 bis xm angeschlossen, während der andere Anschluß über die eine Diode Ds an die zugeordnete Zeilen-Setzleitung ys1 bis ysn und über die andere Diode Dr an die zugeordnete Zeilen-Rücksetzleitung yr1 bis yrn angeschlossen ist. Beim Setzen wird Spalte um Spalte mit einem Setzgegenpotential -Us beaufschlagt. Bei jeder impulsförmigen Spaltenansteuerung werden die Zeilen-Setzleitungen ys1 bis ysn synchron und impulsförmig nacheinander mit einem Setzpotential +Us beaufschlagt. Die Setzinformation liefert ein nicht dargestellter Prozessor P an einen Spaltendekoder Dx und einen Zeilendekoder Dy. Wie mit Schaltern s1 und u1 angedeutet ist, wird bei dem in Fig. 1 gezeigten Steuervorgang nur der dick ausgezogene Stromkreis wirksam. Schematisch angegebene Kontakte s1 bis sn, r1 bis rn und u1 bis un geben die Adressierung weiter.

Damit zusammen mit dem Setzvorgang die Matrix überprüft werden kann, ist an jede Spaltenleitung x1 bis xm eine auf das Setzgegenpotential -Us ansprechende Optokoppler-Leuchtdiode Osx1 bis Osxm angeschaltet. An die Zeilen-Setzleitungen ys1 bis ysn sind auf das Setzpotential ansprechende Optokoppler-Leuchtdioden Osy1 bis Osyn angeschaltet. Die Optokoppler-Leuchtdioden Osx1 bis Osxm der Spaltenleitungen x1 bis xm sind mit dem Setzpotential +Us und die Optokoppler-Leuchtdioden Osy1 bis Osyn der Zeilen-Setzleitungen ys1 bis ysn mit dem Setzgegenpotential -Us verbunden.

Wird der mit R bezeichnete Elektromagnet angesteuert, der über die Adressierung des Spaltendekoders Dx und des Zeilendekoders Dy auf der Spaltenleitung x1 mit Setzgegenpotential -Us und über die Zeilen-Setzleitung ys1 erfolgt, dann sprechen nur die Optokoppler-Leuchtdioden Osx1 und Osy1 an, wenn die Matrix keinen Fehler aufweist. Die Ausgangssignale dieser beiden Optokoppler-Leuchtdioden werden über nicht dargestellte Fotoempfänger dieser Optokoppler einem Codewandler Dz zugeführt. Über den Codewandler Dz werden diese Ausgangssignale in eine binäre Information umgewandelt, die auf einer reduzierten Anzahl z von Informationsleitungen zu einem Prozessor P gelangt. Diese Information kann im Prozessor P auf einfache Weise mit der anstehenden Setzinformation verglichen werden. Wird dabei Übereinstimmung festgestellt, dann liegt in der Matrix M kein Fehler vor und es wird auch kein Fehlersignal abgegeben.

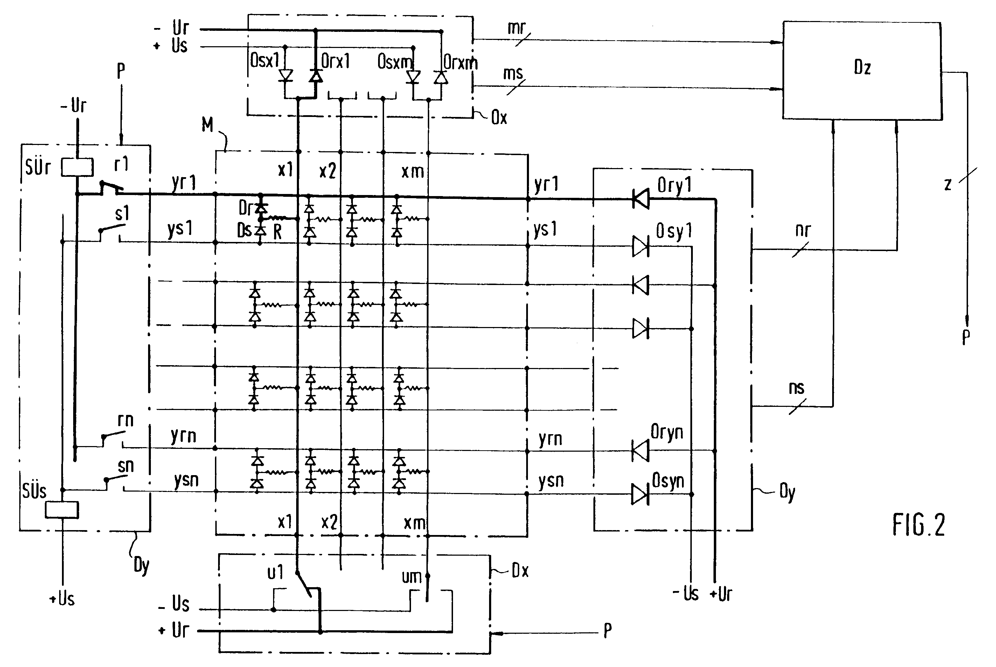

Mit fortschreitendem Steuerzyklus werden der Reihe nach die übrigen Zeilen-Setzleitungen bis ysn angesteuert, wobei jedesmal die Spaltenleitung x1 impulsförmig mit angesteuert wird. Dann wiederholt sich dasselbe Spiel mit der Spaltenleitung x2 und wieder allen Zeilen-Setzleitungen ys1 bis ysn bis schließlich am Ende des Steuerzyklus die Spaltenleitung xm in den Unterzyklus mit den Zeilen-Setzleitungen ys1 bis ysn angesteuert wird. Auf diese Weise werden nacheinander alle Matrixpunkte angesteuert und gesetzt, wenn neben der angesteuerten Spaltenleitung x1 bis xm auch die angesteuerte Zeilen-Setzleitung ys1 bis ysn das richtige Potential erhält. Kontakte s1 können dabei entsprechend den zu setzenden Matrixpunkten vom Prozessor P ausgewählt und über den Zeilen-Dekoder Dy angesteuert werden. Bei einem Steuertakt eines nicht zu setzenden Matrixpunktes darf daher kein Optokoppler ansprechen, während bei einem zu setzenden Matrixpunkt die mit der zugeordneten Spaltenleitung, z.B. x1, und der zugeordneten Zeilen-Setzleitung, z.B. ys1, verbundenen Optokoppler-Leuchtdioden Osx1 und Osy1 ansprechen müssen. Auf diese Weise erfolgt mit jedem Steuertakt eine Überprüfung der angesteuerten Matrixpunkte und daher auch der Matrix M. Die den Spaltenleitungen x1 bis xm zugeordneten Optokoppler-Leuchtdioden Osx1 bis Osxm werden mit den ebenfalls den Spaltenleitungen zugeordneten Optokoppler-Leuchtdioden Orx1 bis Orxm zu einer Baueinheit Ox zusammengefaßt, die für die Überprüfung der Matrix M beim Rücksetzvorgang erforderlich sind. Diese Optokoppler-Leuchtdioden Orx1 bis Orxm sind mit dem Rücksetzpotential -Ur verbunden und sprechen an, wenn auf die Spaltenleitungen x1 bis xm das Rücksetzgegenpotential +Ur geschaltet wird. Wie die Fig. 2 zeigt, erfolgt dies im Spaltendekoder Dx mit schematisch angedeuteten Adressierungskontakten u1 bis um, die vom Prozessor P gesteuert werden.

Außerdem sind an die Zeilen-Rücksetzleitungen yr1 bis yrn die Optokoppler-Leuchtdioden Ory1 bis Oryn angeschaltet, die mit dem Rücksetzgegenpotential +Ur verbunden sind und ansprechen, wenn die zugeordnete Zeilen-Rücksetzleitung yr1 bis yrn das Rücksetzpotential -Ur führt.

Beim Rücksetzen erhält der Elektromagnet R über die Diode Dr seinen Strom, während beim Setzen des Elektromagneten R der Strom über die Diode Ds fließt. Setzen und Rücksetzen erfolgt also durch Stromumkehr. Während beim Setzen im Zeilen-Dekoder Dy die Ansteuerung der Zeilen-Setzleitungen ys1 bis ysn entsprechend der gewünschten Einstellung abhängig von der Stellung der Kontakte s1 bis sn ist, werden die Spaltenleitungen x1 bis xm in jedem Steuertakt mit dem Setzgegenpotential -Us beaufschlagt. Beim Rücksetzen werden dagegen alle Zeilen-Rücksetzleitungen yr1 bis yrn in den zugeordneten Steuertakten mit dem Rücksetzpotential -Ur beaufschlagt, während den Spaltenleitungen x1 bis xm in den Steuertakten das Rücksetzgegenpotential +Ur zugeführt wird. Auf diese Weise werden auch beim Steuerzyklus des Rücksetzens die Matrixpunkte und damit die Matrix M auf Fehler überprüft.

Auch die den Zeilen-Setzleitungen ys1 bis ysn und den Zeilen-Rücksetzleitungen yr1 bis yrn zugeordneten Optokoppler-Leuchtdioden Osy1 bis Osyn und Ory1 bis Oryn mit den nachgeschalteten Fotoempfängern werden zu einer Einheit Oy zusammengefaßt. Die Einheit Ox hat m Setzleitungen ms und m Rücksetzleitungen mr, während die Einheit Oy entsprechend der Zeilenzahl n Setzausgänge ns und n Rücksetzausgänge nr hat. Die Überprüfung in einem Steuertakt ist sehr einfach, denn in der Steuerpause darf keiner dieser Ausgänge ein Signal führen. Bei einem Setztakt darf nur ein einziger Setzausgang ms und ein einziger Setzausgang ns ein Ausgangssignal führen, während bei einem Rücksetztakt nur ein einziger Rücksetzausgang mr und ein einziger Rücksetzausgang nr ein Ausgangssignal führen darf. Dabei müssen aber beim Setz- und beim Rücksetztakt diese beiden Ausgangssignale auch gleichzeitig anwesend sein. Fehlt ein Ausgangssignal, dann liegt an dem angesteuerten Matrixpunkt ein Fehler vor.

Um die Überprüfung noch weiterzuführen, wird im Zeilendekoder Dy sowohl beim Setzen als auch beim Rücksetzen der Strom gemessen. Dieser Strom wird durch Stromüberwachungsschaltungen SÜs und SÜr überwacht, er kann in einem vorgegebenen Bereich liegen, der z.B. durch den Minimal- und Maximalstrom eines Matrixpunktes gegeben ist. Auch wenn während eines Setz- oder Rücksetztaktes die Stromüberwachungsschaltung SÜs oder SÜr ein Unter- oder Überschreiten dieses Strombereiches registriert, wird ein Fehlersignal gegeben, da dann ebenfalls ein Fehler in der Matrix vorliegt.

In jedem Setztakt und in jedem Rücksetztakt wird über den Codewandler Dz die der Setz- oder Rücksetzinformation entsprechende Vergleichsinformation abgeleitet, so daß im Prozessor P die Übereinstimmung oder Nichtübereinstimmung mit dieser festgestellt werden kann - Bei Nichtübereinstimmung kann sofort oder auch erst bei mehrmaligem Feststellen der Nichtübereinstimmung das Fehlersignal gegeben werden.

Die Stromüberwachung kann auch anders ausgeführt sein. So ist es möglich, für den Setz- und Rücksetzvorgang eine gemeinsame, zentrale Stromüberwachungsschaltung vorzusehen, die dann im zentralen Stromversorgungsteil der Schaltungsanordnung untergebracht ist.

Das Rücksetzen kann auch so erfolgen, daß eine Spaltenleitung, z.B. x1, zusammen mit mehreren Zeilen-Rücksetzleitungen yr1 bis yrn ansteuerbar ist. Die Ansteuerung erfolgt dabei wieder impulsförmig und synchron. Es werden aber alle an den angesteuerten Zeilen-Rücksetzleitungen yr1 bis yrn angeschalteten und zu der angesteuerten Spaltenleitung x1 führenden Matrixpunkte zurückgesetzt. Für die Stromüberwachung werden dann allen gleichzeitig angesteuerten Zeilen-Rücksetzleitungen getrennte Stromüberwachungsschaltungen zugeordnet. Auch diese Stromüberwachungsschaltungen können mehrfach ausgenützt werden, wenn die Matrix in mehrere solche Zeilenblöcke unterteilt in den Steuerungsablauf des Prozessors einbezogen ist.

## Patentansprüche

1. Schaltungsanordnung für eine Anzeigevorrichtung mit einer aus n Zeilen und m Spalten bestehenden Matrix (M) aus bistabilen Matrixpunkten, die jeweils einen Elektromagneten (R) aufweisen, dessen einer Anschluß mit seiner zugeordneten Spaltenleitung (x1 ... xm) und dessen anderer Anschluß stromrichtungsabhängig über entgegengesetzt gepolte Dioden (Ds, Dr) mit seiner zugeordneten Zeilen-Setzleitung (ys1 ... ysn) und seiner zugeordneten Zeilen-Rücksetzleitung (yr1 ... yrn) verbunden sind, bei der die Spaltenleitungen (x1 ... xm), die Zeilen-Setzleitungen (ys1 ... ysn) und die Zeilen-Rücksetzleitungen (yr1 ... yrn) der Matrix (M) über einen Prozessor (P), einen Spaltendekoder (Dx) und einen Zeilendekoder (Dy) beim Setzen oder Rücksetzen so ansteuerbar sind, daß die Spaltenleitungen (x1 ... xm) zyklisch nacheinander mit Setzgegenpotential (-Us) oder Rücksetzgegenpotential (+Ur) ansteuerbar sind, wobei bei jeder einzelnen Spaltenansteuerung zyklisch nacheinander alle Zeilen-Setzleitungen (ys1 ... ysn) mit Setzpotential (+Us) oder alle Zeilen-Rücksetzleitungen (yr1 ... yrn) mit Rücksetzpotential (-Ur) ansteuerbar sind,
dadurch gekennzeichnet,
daß mit jeder Spaltenleitung (x1 ... xm) eine an dem Setzpotential (+Us) liegende erste Optokoppler-Leuchtdiode (Osx1 ... Osxm) verbunden ist, die bei angelegtem Setzgegenpotential (-Us) ein erstes Ausgangssignal (auf ms) abgibt,
daß mit jeder Spaltenleitung (x1 ... xm) eine an dem Rücksetzpotential (-Ur) liegende zweite Optokoppler-Leuchtdiode (Orx1 ... Orxm) verbunden ist, die bei angelegtem Rücksetzgegenpotential (+UR) ein zweites Ausgangssignal (auf mr) abgibt,
daß mit jeder Zeilen-Setzleitung (ys1 ... ysn) eine an dem Setzgegenpotential (-Us) liegende dritte Optokoppler-Leuchtdiode (Osy1 ... Osyn) verbunden ist, die bei angelegtem Setzpotential (+Us) ein drittes Ausgangssignal (auf ns) abgibt,
daß mit jeder Zeilen-Rücksetzleitung (yr1 ... ynr) eine an dem Rücksetzgegenpotential (+Ur) liegende vierte Optokoppler-Leuchtdiode (Ory1 ... Oryn) verbunden ist, die bei angelegtem Rücksetzpotential (Ur) ein viertes Ausgangssignal (auf nr) abgibt,
daß die Optokoppler-Leuchtdioden (Osx1 ... Osxm; Orx1 ... Orxm; Osy1 ... Osyn; Ory1 ... Oryn) mittels zugeordneter Fotoempfänger Ausgangssignale (ms, mr, ns, nr) einem Codewandler (Dz) zuführen, der eine Vergleichsinformation an den Prozessor (P) abgibt, und daß der Prozessor (P) diese Vergleichsinformation auf Übereinstimmung mit dar dem Spaltendekoder (Dx) und dem Zeilendekoder (Dy) zugeführten Setz- oder Rücksetzinformation überprüft und bei ein- oder mehrmaligem Fehlen der Übereinstimmung ein Fehlersignal abgibt.

2. Schaltungsanordnung nach Anspruch 1,
dadurch gekennzeichnet,
daß mittels Stromüberwachungsschaltungen (SÜs, SÜr) beim Setzen und Rücksetzen ein vorgebbarer Strombereich überwacht ist.

3. Schaltungsanordnung nach Anspruch 2,
dadurch gekennzeichnet,
daß der vorgebbare Strombereich des durch den Matrixpunkt fließenden Minimal- und Maximalstrom vorgegeben ist.

4. Schaltungsanordnung nach Anspruch 2 oder 3,
dadurch gekennzeichnet,
daß die Stromüberwachungsschaltungen (SÜs, SÜr) im Zeilen-Dekoder (Dy) in die Leitungen zum Setz- und Rücksetzpotential (+Us und -Ur) eingeschleift sind.

5. Schaltungsanordnung nach einem der Ansprüche 2 bis 4,
dadurch gekennzeichnet,
daß das Fehlersignal auch auftritt, wenn die Stromüberwachungsschaltungen (SÜr, SÜs) ein Unter- oder Überschreiten des vorgebbaren Strombereiches feststellen.

6. Schaltungsanordnung nach einem der Ansprüche 1 bis 5,
dadurch gekennzeichnet,
daß die Ansteuerung der Spaltenleitungen (x1 ... xm) mit dem Setzgegenpotential (-Us) bzw. dem Rücksetzgegenpotential (+Ur) und die Ansteuerung der Zeilen-Setzleitungen (ys1 ... ysn) mit Setzpotential (+Us) bzw. der Zeilen-Rücksetzleitungen (yr1 ... yrn) mit Rücksetzpotential (-Ur) synchron und impulsförmig erfolgen.

7. Schaltungsanordnung nach Anspruch 1,
dadurch gekennzeichnet,
daß der Setz- und der Rücksetzstromkreis über eine gemeinsame Stromüberwachungsschaltung geführt sind, die im Stromversorgungs-Leistungsteil untergebracht ist.

8. Schaltungsanordnung nach Anspruch 1,
dadurch gekennzeichnet,
daß beim Rücksetzen eine Spaltenleitung (x1 ... xm) und gleichzeitig mehrere Zeilen-Rücksetzleitungen (yr1 ... yrn) ansteuerbar sind und
daß in jede Zeilen-Rücksetzleitung (yr1 ... yrn) eine Stromüberwachungsschaltung eingeschleift ist.

9. Schaltungsanordnung nach Anspruch 1,
wobei in der Definition des Anspruchs 1 die Spalten und die Zeilen der Matrix (M) vertauscht sind.

## Claims

1. Circuit arrangement for an indicating device, having a matrix (M) of bistable matrix points comprising n lines and m columns, each of said matrix points having an electromagnet (R), one connection of which is connected to its associated column line (x1 ... xm), and the other connection of which is connected to its associated line setting line (ys1 ... ysn) and its associated line resetting line (yr1 ... yrn) in dependence on the direction of flow via oppositely poled diodes (Ds, Dr), wherein the column lines (x1 ... xm), the line setting lines (ys1 ... ysn) and the line resetting lines (yr1 ... yrn) of the matrix (M) are actuatable via a processor (P), a column decoder (Dx) and a line decoder (Dy) during the setting or resetting operation so that the column lines (x1 ... xm) are actuatable in successive cycles with setting counter-potential (-Us) or resetting counter-potential (+Ur), all of the line setting lines (ys1 ... ysn) being actuatable with setting potential (+Us) or all of the line resetting lines (yr1 ... yrn) being actuatable with resetting potential (-Ur) in successive cycles for each individual column actuation, characterised in that there is connected to each column line (x1 ... xm) a first optical coupler light-emitting diode (Osx1 ... Osxm), which lies at the setting potential (+Us) and issues a first output signal (on ms) when setting counter-potential (-Us) is applied, in that there is connected to each column line (x1 ... xm) a second optical coupler light-emitting diode (Orx1 ... Orxm), which lies at the resetting potential (-Ur) and issues a second output signal (on mr) when resetting counter-potential (+Ur) is applied, in that there is connected to each line setting line (ys1 ... ysn) a third optical coupler light-emitting diode (Osy1 ... Osyn), which lies at the setting counter-potential (-Us) and issues a third output signal (on ns) when setting potential (+Us) is applied, in that there is connected to each line resetting line (yr1 ... ynr) a fourth optical coupler light-emitting diode (Ory1 ... Oryn), which lies at the resetting counter-potential (+Ur) and issues a fourth output signal (on nr) when resetting potential (-Ur) is applied, in that the optical coupler light-emitting diodes (Osx1 ... Osxm; Orx1 ... Orxm; Osy1 ... Osyn; Ory1 ... Oryn) supply output signals (ms, mr, ns, nr) to a code converter (Dz) by means of associated photoreceivers, said converter giving comparative information to the processor (P), and in that the processor (P) checks to ascertain whether this comparative information agrees with the setting or resetting information supplied to the column decoder (Dx) and the line decoder (Dy) and issues a fault signal if there is a lack of agreement on one or more occasions.

2. Circuit arrangement according to claim 1, characterised in that a predetermined current range is monitored by means of current monitoring circuits (SÜs, SÜr) during the setting and resetting operations.

3. Circuit arrangement according to claim 2, characterised in that the predetermined current range is the minimum and maximum currents flowing through the matrix point.

4. Circuit arrangement according to claim 2 or 3, characterised in that the current monitoring circuits (SÜs, SÜr) in the line decoder (Dy) are incorporated into the lines for the setting and resetting potentials (+Us and -Ur).

5. Circuit arrangement according to one of claims 2 to 4, characterised in that the fault signal also occurs when the current monitoring circuits (SÜr, SÜs) ascertain that the predetermined current range is not reached or is exceeded.

6. Circuit arrangement according to one of claims 1 to 5, characterised in that the actuation of the column lines (x1 ... xm) with the setting counter-potential (-Us) or with the resetting counter-potential (+Ur), and the actuation of the line setting lines (ys1 ... ysn) with setting potential (+Us), or respectively [the actuation] of the line resetting lines (yr1 ... yrn) with resetting potential (-Ur) are effected in a synchronous and pulse-like manner.

7. Circuit arrangement according to claim 1, characterised in that the setting circuit and the resetting circuit are controlled via a common current monitoring circuit which is accommodated in the power supply unit.

8. Circuit arrangement according to claim 1, characterised in that, during the resetting operation, a column line (x1 ... xm) and simultaneously a plurality of line resetting lines (yr1 ... yrn) are actuatable, and in that a current monitoring circuit is incorporated into each line resetting line (yr1 ... yrn).

9. Circuit arrangement according to claim 1, wherein, in the definition of claim 1, the columns and the lines of the matrix (M) are interchanged.

## Revendications

1. Circuit de surveillance pour un dispositif d'affichage avec une matrice (M) de points bistables composée de n lignes et de m colonnes, points bistables qui présentent chacun un électro-aimant (R), dont une borne est connectée à son conducteur de colonne associé (x1.....xm) et dont l'autre borne est en fonction du sens du courant par l'intermédiaire de diodes de polarités opposées (Ds, Dr) connectée à son conducteur de composition de ligne associé (ys1 ...ysn) et à son conducteur d'effacement de ligne associé (yr1...yrn), circuit dans lequel les conducteurs de colonne (x1 .... xm), les conducteurs de composition de ligne (ys1 ... ysn) et les conducteurs d'effacement de ligne (yr1 ... yrn) de la matrice (M) peuvent, par l'intermédiaire d'un processeur (P), d'un décodeur de colonne (Dx) et d'un décodeur de ligne (Dy), lors de la composition ou de l'effacement, être sélectionnés de manière telle que les conducteurs de colonne (x1 ....xm) sont de manière cyclique l'un après l'autre soumis à un contre-potentiel de composition (-Us) ou à un contre-potentiel d'effacement (+Ur), opération lors de laquelle à chaque sélection individuelle de colonne, tous les conducteurs de composition de ligne (ys1 ... ysn) sont de manière cyclique l'un après l'autre soumis au potentiel de composition (+Us) ou tous les conducteurs d'effacement de ligne (yr1 ... yrn) sont de manière cyclique l'un après l'autre soumis au potentiel d'effacement (-Ur), circuit dans lequel pour chaque sélection individuelle de colonne tous les conducteurs de composition de ligne (ys1 ... ysn) peuvent de manière cyclique l'un après l'autre être être excités par le potentiel de composition (+Us) ou tous les conducteurs d'effacement de ligne (yr1 ... ysn) peuvent de manière cyclique l'un après l'autre être excités par le potentiel d'effacement (-Ur)
caractérisé par le fait
qu'à chaque conducteur de colonne (x1....xm) est connectée une première diode lumineuse de couplage optique (Osx1 ... Osxm) soumise au potentiel de composition (+Us), diode qui lorsque le contre-potentiel de composition (-Us) est appliqué émet un premier signal de sortie (sur ms),
qu'à chaque conducteur de colonne (x1 ... xm) est connectée une deuxième diode lumineuse de couplage optique (Orsx1 ... Orsxm) soumise au potentiel d'effacement (-Ur), diode qui lorsque le contre-potentiel d'effacement (+UR) est appliqué émet un deuxième signal de sortie (sur mr),
qu'à chaque conducteur de composition de ligne (ys1 ... ysn) est connectée une troisième diode lumineuse de couplage optique (Osy1 ... Osyn) soumise au contre-potentiel de composition (-Us), diode qui lorsque le potentiel de composition (+Us) est appliqué émet un troisième signal de sortie (sur ns),
qu'à chaque conducteur d'effacement de ligne (yr1 ... ynr) est connectée une quatrième diode lumineuse de couplage optique (Ory1 ... Oryn) soumise au contre-potentiel d'effacement (+Ur), diode qui lorsque le potentiel d'effacement (Ur) est appliqué émet un quatrième signal de sortie (sur nr),
que les diodes lumineuses de couplage optique (Osx1 ... Osxm; Orx1 ... Orxm; Osy1 ... Oryn) transmettent au moyen de photocapteurs associés les signaux de sortie (ms, mr, ns, nr) à un convertisseur de code (Dz), lequel transfère une information de comparaison au processeur (P), et par le fait que le processeur (P) contrôle cette information de comparaison quant à sa concordance avec une information de composition ou d'effacement transférée au décodeur de colonne (Dx) et au décodeur de ligne (Dy) et qui en cas d'une ou de plusieurs absences de concordance émet un signal d'erreur.

2. Circuit suivant la revendication 1,
caractérisé par le fait
qu'au moyen de circuits de surveillance d'intensité (SÜs , SÜr), une gamme d'intensités de consigne est surveillée lors de la composition et de l'effacement.

3. Circuit suivant la revendication 2,
caractérisé par le fait
que la gamme d'intensités de consigne est fonction du courant minimal et maximal circulant dans le point matriciel.

4. Circuit suivant la revendication 2 ou la revendication 3,
caractérisé par le fait
que les circuits de surveillance d'intensité (SÜs, SÜr) dans le décodeur de ligne (Dy) sont noyés dans les conducteurs vers le potentiel de composition et d'effacement (+Us et -Ur).

5. Circuit suivant l'une quelconque des revendications de 2 à 4,
caractérisé par le fait
que le signal d'erreur est également engendré lorsque les circuits de surveillance d'intensité (SÜs, SÜr) détectent une intensité inférieure ou supérieure à la gamme d'intensités de consigne.

6. Circuit suivant l'une quelconque des revendications de 1 à 5,
caractérisé par le fait
que l'excitation des conducteurs de colonne (x1 ... xm) par le contre-potentiel de composition (-Us) ou par le contre-potentiel d'effacement (+Ur) et l'excitation des conducteurs de composition de ligne (ys1 ... ysn) par le potentiel de composition (+Us) ou des conducteurs d'effacement de ligne (yr1 ... yrn) par le potentiel d'effacement (-Ur) ont lieu de manière synchrone et sous forme d'impulsions.

7. Circuit suivant la revendication 1,
caractérisé par le fait
que les circuits de composition et d'effacement sont connectés à un circuit commun de surveillance d'intensité, lequel est logé dans l'unité d'alimentation électrique.

8. Circuit suivant la revendication 7,
caractérisé par le fait
que lors de l'effacement, un conducteur de colonne (x1 ... xm) et simultanément plusieurs conducteurs d'effacement de ligne (yr1 ... yrn), peuvent être excités et
que dans chaque conducteur d'effacement de ligne (yr1 ... yrn) est noyé un circuit de surveillance d'intensité.

9. Circuit suivant la revendication 1,
dans lequel dans la définition de la revendication 1 sont interchangés les colonnes et les lignes de la matrice (M).
